# EUROPEAN PATENT SPECIFICATION

(11) **EP 2 388 346 B1**
(45) Date of publication and mention of the grant of the patent: **22.05.2019**
(21) Application number: 11177836.1
(22) Date of filing: 21.08.2006
(51) Int. Cl.: C22B 34/24, C22B 9/20, C22C 27/02, C22F 1/18, C23C 14/34, H05H 7/20

(54) **Production of fine grain niobium products by micro-alloying and ingot metallurgy**
Herstellung von Feinkorn-Nioberzeugnissen mittels Mikrolegieren und Blockmetallurgie
Fabrication de produits de niobium à grain fin par microalliage et métallurgie de lingots

(30) Priority: 31.08.2005 US 216498
(43) Date of publication of application: 23.11.2011
(62) Divisional of application: 06813595.3
(73) Proprietor: H.C. Starck Inc., Newton, MA 02324-2275 (US)
(72) Inventor: Aimone, Paul, Bridgewater, MA Massachusetts 02324-2275 (US)
(74) Representative: Maiwald Patent- und Rechtsanwaltsgesellschaft mbH

(56) References cited:
- EP-A- 1 652 945
- WO-A-92/20828
- WO-A2-02/088412
- US-A- 5 846 287

## Description

The present invention relates to a method of making a niobium-containing wrought product, a niobium-containing wrought product obtained according to this method, and deep drawn cups and sputtering targets prepared from the niobium-containing wrought product.

Niobium ingots can be rolled to plate and sheet dimensions using known methods in the art. Such plates and sheets can be used, for example, by being deep drawn into cups for the synthetic diamond industry. The niobium foil used typically has an inconsistent and coarse grain size, which leads to poor flatness and smoothness of the deep drawn cup bottom. Poor flatness and/or smoothness (orange peel) result in a synthetic diamond that requires excessive grinding to correct deficiencies.

The problem ultimately relates to a coarse grain structure in the niobium sheet.

The coarse grain structure can also cause tearing of the sheet during deep-draw operations.

The grain size of typical, commercially available niobium sheet is variable, ranging from an ASTM grain size of from 4 to 10. It is, however, desirable to use niobium sheet with an ASTM grain size finer than 7.5 with at least 90% recrystallization for deep draw applications, although this still produces a high rejection rate for flatness and surface finish. An ASTM grain size finer than 8.0 with at least 90% recrystallization almost completely eliminates these issues.

It would be desirable to provide a method of producing niobium sheet having a consistent ASTM grain size and sufficient recrystallization to minimize or prevent flatness and/or smoothness problems with the sheet. US 20060086438 A1 describes a silicon-containing alloy of niobium that solves the above-identified problem. WO 92/20828 discloses a method wherein niobium powder is blended with a dopant powder, the dopant containing a metallic and a non-metallic component, e.g. yttrium nitride; followed by sintering.

### DESCRIPTION OF THE INVENTION

The present invention is directed to a method of making a niobium-containing wrought product comprising:a) melting niobium to form a melt;b) adding 0.1 to 60 ppm of a metal selected from the group consisting of yttrium, aluminum, hafnium, titanium, zirconium, thorium, lanthanum and cerium, based on the niobium in the melt;c) cooling the melt to form an alloy ingot;d) applying thermo-mechanical processing steps to the alloy ingot to form a wrought product.

In another aspect, the present invention is directed to a niobium containing wrought product obtained according to the method of the present invention,wherein a wrought product having one of the following compositions is excluded:- 0.40 ppm Si, 0.02 ppm B, 0.02 ppm Na, 0.07 ppm Al, 0.37 ppm P, 0.53 ppm S, < 0.01 ppm Cl, 0.08 ppm Ti, 0.02 ppm V, 0.03 ppm Cr, < 0.005 ppm Mn, 0.15 ppm Fe, < 0.001 ppm Co, 0.005 ppm Ni, < 0.01 ppm Cu, < 0.001 ppm Y, 0.21 ppm Zr, 4.5 ppm Mo, 0.03 ppm Hf, ≤ 1000 ppm Ta, 1.5 ppm W, 5 ppm C, 6 ppm N, 33 ppm O, the balance being niobium;
- 20 ppm Si, 0.05 ppm B, < 0.01 ppm Na, 0.07 ppm Al, 0.75 ppm P, 0.01 ppm S, < 0.01 ppm Cl, 0.05 ppm Ti, 0.04 ppm V, 0.07 ppm Cr, 1.1 ppm Mn, 0.05 ppm Fe, 0.01 ppm Co, 0.04 ppm Ni, < 0.01 ppm Cu, 0.003 ppm Y, 0.19 ppm Zr, 4.3 ppm Mo, 0.02 ppm Hf, ≤ 1000 ppm Ta, 3.9 ppm W, 8 ppm C, 4 ppm N, 28 ppm O, the balance being niobium;
- 31 ppm Si, 0.09 ppm B, < 0.01 ppm Na, 0.05 ppm Al, 0.75 ppm P, 0.05 ppm S, 0.05 ppm Cl, 0.07 ppm Ti, 0.02 ppm V, 0.05 ppm Cr, < 0.005 ppm Mn, . 0.49 ppm Fe, 0.03 ppm Co, 0.01 ppm Ni, 0.02 ppm Cu, 0.003 ppm Y, 0.19 ppm Zr, 4.5 ppm Mo, 0.02 ppm Hf, ≤ 1000 ppm Ta, 1.5 ppm W, 8 ppm C, 8 ppm N, 31 ppm O, the balance being niobium;
- 29 ppm Si, 0.03 ppm B, 0.03 ppm Na, 0.09 ppm Al, 2.1 ppm P, 0.92 ppm S, < 0.01 ppm Cl, 0.06 ppm Ti, 0.02 ppm V, 0.05 ppm Cr, < 0.005 ppm Mn, 0.42 ppm Fe, 0.002 ppm Co, 0.02 ppm Ni, < 0.01 ppm Cu, < 0.001 ppm Y, 0.21 ppm Zr, 4.3 ppm Mo, 0.04 ppm Hf, ≤ 1000 ppm Ta, 2.5 ppm W, 4 ppm C, 12 ppm N, 58 ppm O, the balance being niobium;
- 40 ppm Si, 0.09 ppm B, < 0.01 ppm Na, 0.15 ppm Al, 0.52 ppm P, 0.05 ppm S, < 0.01 ppm Cl, 0.04 ppm Ti, 0.02 ppm V, 0.05 ppm Cr, < 0.005 ppm Mn, 0.27 ppm Fe, < 0.001 ppm Co, 0.009 ppm Ni, 0.02 ppm Cu, < 0.001 ppm Y, 0.15 ppm Zr, 3.8 ppm Mo, < 0.01 ppm Hf, ≤ 800 ppm Ta, 1.5 ppm W, 5 ppm C, 9 ppm N, 33 ppm O, the balance being niobium;
- 60 ppm Si, 0.05 ppm B, < 0.01 ppm Na, 0.08 ppm Al, 1.9 ppm P, 0.53 ppm S, < 0.01 ppm Cl, 0.03 ppm Ti, 0.01 ppm V, 0.03 ppm Cr, < 0.005 ppm Mn, 0.51 ppm Fe, < 0.001 ppm Co, 0.02 ppm Ni, 0.05 ppm Cu, 0.005 ppm Y, 0.22 ppm Zr, 3.7 ppm Mo, 0.02 ppm Hf, ≤ 1000 ppm Ta, 2.5 ppm W, 7 ppm C, 4 ppm N, 42 ppm O, the balance being niobium.

In another aspect, the present invention is additionally directed to deep drawn cups and sputtering targets made from the niobium-containing wrought product described above.

Other than in the operating examples, or where otherwise indicated, all numbers or expressions referring to quantities of ingredients, reaction conditions, etc. used in the specification and claims are to be understood as modified in all instances by the term "about."

The present invention relates to a method for manufacturing niobium wrought products. The method provides a significant reduction as well as better control of the final grain size in niobium wrought products. More particularly, the present invention provides niobium wrought products that contain greater than 5 ppm of the alloying metal, which has a consistently fine, uniform, and fully recrystallized grain structure.

As used herein, the term "wrought products" refers generally to metals that have been exposed to thermo-mechanical processing steps to acquire a specific shape and/or other properties. The thermal steps can include, but are not limited to annealing, baking, smelting and/or melting. The mechanical steps can include, but are not limited to working, forging, rolling, upset forging, upset-and-forge-back techniques, hammer forging, drawback forging, flat forging, round forging, and radial forging.

Wrought products, as provided in the present invention include, but are not limited to generally planar metal forms such as foils (less than about 0.25 mm (10 mil) in thickness), sheets (from about 0.25 mm to about 3.18 mm (10 to about 125 mil) in thickness), and plates (greater than about 3.18 mm (125 mil) in thickness). Other wrought product forms can include tubes, where a length of metal is hollow in the center (and can have any cross-sectional internal and external shape, but often those shapes will be circular, oval, square, rectangular, triangular, hexagonal, or octagonal); and rods, which are lengths of metal that are solid throughout and can have any cross sectional internal and external shape, but often those shapes will be circular, oval, square, rectangular, triangular, hexagonal, or octagonal.

In the invention, vacuum arc remelting is used to alloy niobium with low level metal additions along with traditional thermo-mechanical processing with higher annealing temperatures to produce niobium wrought products with a fine and fully recrystallized grain structure. The inventive process provides high yields, a more consistent product, and lower manufacturing costs.

In an embodiment of the present invention, the metal selected from the group consisting of yttrium, aluminum, hafnium, titanium, zirconium, thorium, lanthanum and cerium is present at a level of at least 0.01 ppm, in some cases 0.1 ppm and as high as 60 ppm, in some cases 50 ppm based on the total niobium in the niobium ingot. The amount of metal in the niobium can be any value or can range between any of the values recited above.

In the present method, a blend containing niobium powder and a metal powder selected from the group consisting of yttrium, aluminum, hafnium, titanium, zirconium, thorium, lanthanum and cerium is formed and pressed to form a pressed blend. As used herein, the term "pressed blend" refers to a solid form where a mixture of materials are compressed to form a stable shape, which is capable of being attached to another body, such that when the other body melts, the pressed blend melts and commingles with the elements of the other body.

The pressed blends are attached to electrodes that contain niobium using a suitable method and both are melted under vacuum arc remelting (VAR) conditions and subsequently cooled. In other words, the niobium acts as an electrode, and is melted by striking an arc between a charged electrode and the niobium, under vacuum. The arc power can be from 25 to 50V and from 7,000 to 10,000 amps.

Typically, a pressed blend of niobium and the metal selected from the group consisting of yttrium, aluminum, hafnium, titanium, zirconium, thorium, lanthanum and cerium is used with a niobium electrode.

The melted electrode and pressed blend is cooled to form an alloy ingot.

Thermo-mechanical processing steps as indicated above are applied to the alloy ingot to form a wrought product as described above.

After forging, the alloy ingot can be vacuum annealed at a temperature of at least 950°C and up to 1150°C. The annealing temperature for the wrought product can be any value or range between the values recited above.

The annealing step can take at least 5 minutes and up to 180 minutes. The length of time for annealing can be any value or can range between any values recited above.

The annealing step can result in at least 75% recrystallization and in some cases up to at least 95% recrystallization.

In an embodiment of the invention, sequential rolling and annealing steps can be carried out on the alloy ingot. Any suitable combination of rolling and annealing steps can be used. In a particular embodiment of the invention, the following steps are used:
I) rolling the wrought product to an intermediate thickness;
II) annealing the wrought product of I) at a temperature of from 950 to 1150°C for a period of from 30 minutes to 180 minutes;
III) rolling the wrought product of II); and
IV) annealing the wrought product of III) at a temperature of from 950 to 1150°C for a period of from 30 minutes to 180 minutes and then cooling the wrought product to room temperature.

In an embodiment of the invention, the intermediate thickness I) can be from 0.5 to 2 cm and the wrought product III) can have a thickness of from 0.005 to 0.24 cm.

A particular embodiment of the invention provides a method of making an alloy of niobium by
a) melting niobium to form a melt;
b) adding 0.1 to 60 ppm of a metal selected from the group consisting of yttrium, aluminum, hafnium, titanium, zirconium, thorium, lanthanum and cerium, based on the niobium in the melt;
c) cooling the melt to form an alloy ingot;
d) applying thermo-mechanical processing steps to the alloy ingot to form a wrought product.

The thermo-mechanical processing steps in d) can include i) forging the alloy ingot to form a wrought product; and ii) annealing the wrought product at a temperature of from 950 to 1150°C.

Particular sequential rolling and annealing steps can be used in this particular embodiment as described above. The annealing steps can result in at least 75% recrystallization and in some cases up to at least 95% recrystallization.

In an alternative embodiment, scrap niobium is consolidated via VAR, ISM, or other cold hearth melting techniques and the metal (selected from the group consisting of yttrium, aluminum, hafnium, titanium, zirconium, thorium, lanthanum and cerium) addition made directly to the melt or via the VAR process described above.

In the present invention, the cooled, annealed plate and sheet has a fine and uniform ASTM grain size up to 10, and can be as coarse as 5. In an embodiment of the invention, the ASTM grain size is in the range of 8 to 10.

The present invention also provides for wrought product made according to the above described processes, where the wrought products are selected from a foil, a sheet, a plate, a tube, and a rod.

The present invention also provides for deep drawn cups or sputtering targets obtained using, made from, or including the above-described wrought products.

Not wishing to be bound to a single theory, it is believed that the metal (selected from the group consisting of yttrium, aluminum, hafnium, titanium, zirconium, thorium, lanthanum and cerium) combines with niobium to form alloy particles in the niobium or possibly with oxygen to produce sub-micron size oxides of the respective metal added. Rolling (cold working) to sheet produces a uniform dispersion of these particles that on subsequent annealing act initially as grain nucleation sites and, with continued annealing, as grain boundary pinning points. Considering the statements made above, the following embodiments are further disclosed:
Embodiment {01} relates to a method of making an alloy of niobium comprising:A) forming a blend comprising niobium powder and a powder of a metal selected from the group consisting of yttrium, aluminum, hafnium, titanium, zirconium, thorium, lanthanum and cerium and pressing the blend to form pressed blend;B) attaching the pressed blend to an electrode comprising niobium;C) melting the electrode and pressed blend under vacuum arc remelting conditions, such that the blend mixes with the melted electrode;D) cooling the melted electrode to form an alloy ingot; andE) applying thermo-mechanical processing steps to the alloy ingot to form a wrought product.
Embodiment {02} relates to the method according to Embodiment {01}, wherein the wrought product in E) has a fine and uniform ASTM grain size of from 5 to 10.
Embodiment {03} relates to the method according to Embodiment {01}, wherein the metal is present in A) at from 0.1 to 100 ppm based on total niobium in the wrought product.
Embodiment {04} relates to the method according to Embodiment {01}, wherein the thermo-mechanical processing steps in E) comprise:
   i) forging the alloy ingot to form a wrought product; and
   ii) annealing the wrought product at a temperature of from 950 to 1150°C.
Embodiment {05} relates to the method according to Embodiment {04}, wherein the wrought product is selected from the group consisting of foils, sheets, plates, tubes, and rods.
Embodiment {06} relates to the method according to Embodiment {04}, wherein the annealing in i) results in at least 75% recrystallization.
Embodiment {07} relates to the method according to Embodiment {01}, wherein the thermo-mechanical processing steps in E) comprise:
   I) rolling the wrought product to an intermediate thickness;
   II) annealing the wrought product of I) at a temperature of from 950 to 1150°C for a period of from 30 minutes to 180 minutes;
   III) rolling the wrought product of II); and
   IV) annealing the wrought product of III) at a temperature of from 950 to 1150°C for a period of from 30 minutes to 180 minutes and then cooling the wrought product to room temperature.
Embodiment {08} relates to the method according to Embodiment {06}, wherein the wrought product is selected from the group consisting of foils, sheets, plates, tubes, and rods.
Embodiment {09} relates to the method according to Embodiment {07}, wherein the annealing in II) and IV) result in at least 75% recrystallization.
Embodiment {10} relates to a niobium containing wrought product obtained according to the method of Embodiment {01}.
Embodiment {11} relates to the wrought product according to Embodiment {10}, wherein the wrought product is selected from the group consisting of a foil, a sheet, a plate, a tube, and a rod.
Embodiment {12} relates to deep drawn cups prepared from the wrought product according to Embodiment {10}.
Embodiment {13} relates to sputtering targets prepared from the wrought product according to Embodiment {10}.
Embodiment {14} relates to a method of making an alloy of niobium comprising:
   a) melting niobium to form a melt;
   b) adding 0.1 to 60 ppm of a metal selected from the group consisting of yttrium, aluminum, hafnium, titanium, zirconium, thorium, lanthanum and cerium, based on the niobium in the melt;
   c) cooling the melt to form an alloy ingot;
   d) applying thermo-mechanical processing steps to the alloy ingot to form a wrought product.
Embodiment {15} relates to the method according to Embodiment {14}, wherein the wrought product has a fine and uniform ASTM grain size of from 5 to 10.
Embodiment {16} relates to the method according to Embodiment {14}, wherein the metal is present in b) at from 0.1 to 100 ppm based on total niobium.
Embodiment {17} relates to the method according to Embodiment {14}, wherein the thermo-mechanical processing steps in d) comprise:
   i) forging the alloy ingot to form a wrought product; and
   ii) annealing the wrought product at a temperature of from 950 to 1150°C.
Embodiment {18} relates to the method according to Embodiment {17}, wherein the wrought product is selected from the group consisting of foils, sheets, plates, tubes, and rods.
Embodiment {19} relates to the method according to Embodiment {17}, wherein the annealing in i) results in at least 75% recrystallization.
Embodiment {20} relates to the method according to Embodiment {14}, wherein the thermo-mechanical processing steps in d) comprise:
   I) rolling the wrought product to an intermediate thickness;
   II) annealing the wrought product of I) at a temperature of from 950 to 1150°C for a period of from 30 minutes to 180 minutes;
   III) rolling the wrought product of II); and
   IV) annealing the wrought product of III) at a temperature of from 950 to 1150°C for a period of from 30 minutes to 180 minutes and then cooling the wrought product to room temperature.
Embodiment {21} relates to the method according to Embodiment {20}, wherein the wrought product is selected from the group consisting of foils, sheets, plates, tubes, and rods.
Embodiment {22} relates to the method according to Embodiment {21}, wherein the annealing in II) and IV) result in at least 75% recrystallization.
Embodiment {23} relates to a niobium containing wrought product obtained according to the method of Embodiment {14}.
Embodiment {24} relates to the wrought product according to Embodiment {23}, wherein the wrought product is selected from the group consisting of a foil, a sheet, a plate, a tube, and a rod.
Embodiment {25} relates to deep drawn cups prepared from the wrought product according to Embodiment {23}.
Embodiment {26} relates to sputtering targets prepared from the wrought product according to Embodiment {24}.

## Claims

1. A method of making a niobium-containing wrought product comprising:
a) melting niobium to form a melt;
b) adding 0.1 to 60 ppm of a metal selected from the group consisting of yttrium, aluminum, hafnium, titanium, zirconium, thorium, lanthanum and cerium, based on the niobium in the melt;
c) cooling the melt to form an alloy ingot;
d) applying thermo-mechanical processing steps to the alloy ingot to form a wrought product.

2. The method according to Claim 1, wherein the wrought product has a fine and uniform ASTM grain size of from 5 to 10.

3. The method according to Claim 1, wherein the thermo-mechanical processing steps in d) comprise:
i) forging the alloy ingot to form a wrought product; and
ii) annealing the wrought product at a temperature of from 950 to 1150°C.

4. The method according to Claim 3, wherein the wrought product is selected from the group consisting of foils, sheets, plates, tubes, and rods.

5. The method according to Claim 3, wherein the annealing in ii) results in at least 75% recrystallization.

6. The method according to Claim 1, wherein the thermo-mechanical processing steps in d) comprise:
I) rolling the wrought product to an intermediate thickness;
II) annealing the wrought product of I) at a temperature of from 950 to 1150°C for a period of from 30 minutes to 180 minutes;
III) rolling the wrought product of II); and
IV) annealing the wrought product of III) at a temperature of from 950 to 1150°C for a period of from 30 minutes to 180 minutes and then cooling the wrought product to room temperature.

7. The method according to Claim 6, wherein the wrought product is selected from the group consisting of foils, sheets, plates, tubes, and rods.

8. The method according to Claim 7, wherein the annealing in II) and IV) result in at least 75% recrystallization.

9. A niobium containing wrought product obtained according to the method of Claim 1, wherein a wrought product having one of the following compositions is excluded:
- 0.40 ppm Si, 0.02 ppm B, 0.02 ppm Na, 0.07 ppm Al, 0.37 ppm P, 0.53 ppm S, < 0.01 ppm Cl, 0.08 ppm Ti, 0.02 ppm V, 0.03 ppm Cr, < 0.005 ppm Mn, 0.15 ppm Fe, < 0.001 ppm Co, 0.005 ppm Ni, < 0.01 ppm Cu, < 0.001 ppm Y, 0.21 ppm Zr, 4.5 ppm Mo, 0.03 ppm Hf, ≤ 1000 ppm Ta, 1.5 ppm W, 5 ppm C, 6 ppm N, 33 ppm O, the balance being niobium;
- 20 ppm Si, 0.05 ppm B, < 0.01 ppm Na, 0.07 ppm Al, 0.75 ppm P, 0.01 ppm S, < 0.01 ppm Cl, 0.05 ppm Ti, 0.04 ppm V, 0.07 ppm Cr, 1.1 ppm Mn, 0.05 ppm Fe, 0.01 ppm Co, 0.04 ppm Ni, < 0.01 ppm Cu, 0.003 ppm Y, 0.19 ppm Zr, 4.3 ppm Mo, 0.02 ppm Hf, ≤ 1000 ppm Ta, 3.9 ppm W, 8 ppm C, 4 ppm N, 28 ppm O, the balance being niobium;
- 31 ppm Si, 0.09 ppm B, < 0.01 ppm Na, 0.05 ppm Al, 0.75 ppm P, 0.05 ppm S, 0.05 ppm Cl, 0.07 ppm Ti, 0.02 ppm V, 0.05 ppm Cr, < 0.005 ppm Mn, 0.49 ppm Fe, 0.03 ppm Co, 0.01 ppm Ni, 0.02 ppm Cu, 0.003 ppm Y, 0.19 ppm Zr, 4.5 ppm Mo, 0.02 ppm Hf, ≤ 1000 ppm Ta, 1.5 ppm W, 8 ppm C, 8 ppm N, 31 ppm O, the balance being niobium;
- 29 ppm Si, 0.03 ppm B, 0.03 ppm Na, 0.09 ppm Al, 2.1 ppm P, 0.92 ppm S, < 0.01 ppm Cl, 0.06 ppm Ti, 0.02 ppm V, 0.05 ppm Cr, < 0.005 ppm Mn, 0.42 ppm Fe, 0.002 ppm Co, 0.02 ppm Ni, < 0.01 ppm Cu, < 0.001 ppm Y, 0.21 ppm Zr, 4.3 ppm Mo, 0.04 ppm Hf, ≤ 1000 ppm Ta, 2.5 ppm W, 4 ppm C, 12 ppm N, 58 ppm O, the balance being niobium;
- 40 ppm Si, 0.09 ppm B, < 0.01 ppm Na, 0.15 ppm Al, 0.52 ppm P, 0.05 ppm S, < 0.01 ppm Cl, 0.04 ppm Ti, 0.02 ppm V, 0.05 ppm Cr, < 0.005 ppm Mn, 0.27 ppm Fe, < 0.001 ppm Co, 0.009 ppm Ni, 0.02 ppm Cu, < 0.001 ppm Y, 0.15 ppm Zr, 3.8 ppm Mo, < 0.01 ppm Hf, ≤ 800 ppm Ta, 1.5 ppm W, 5 ppm C, 9 ppm N, 33 ppm O, the balance being niobium;
- 60 ppm Si, 0.05 ppm B, < 0.01 ppm Na, 0.08 ppm Al, 1.9 ppm P, 0.53 ppm S, < 0.01 ppm Cl, 0.03 ppm Ti, 0.01 ppm V, 0.03 ppm Cr, < 0.005 ppm Mn, 0.51 ppm Fe, < 0.001 ppm Co, 0.02 ppm Ni, 0.05 ppm Cu, 0.005 ppm Y, 0.22 ppm Zr, 3.7 ppm Mo, 0.02 ppm Hf, ≤ 1000 ppm Ta, 2.5 ppm W, 7 ppm C, 4 ppm N, 42 ppm O, the balance being niobium.

10. The wrought product according to Claim 9, wherein the wrought product is selected from the group consisting of a foil, a sheet, a plate, a tube, and a rod.

11. Deep drawn cups prepared from the wrought product according to Claim 9.

12. Sputtering targets prepared from the wrought product according to Claim 9.

## Patentansprüche

1. Verfahren zur Herstellung eines Niob-haltigen Knetprodukts, umfassend:
a) Schmelzen von Niob unter Bildung einer Schmelze;
b) Zugabe von 0,1 bis 60 ppm eines Metalls, ausgewählt aus der Gruppe, bestehend aus Yttrium, Aluminium, Hafnium, Titan, Zirkonium, Thorium, Lanthan und Cer, bezogen auf das Niob in der Schmelze;
c) Abkühlen der Schmelze unter Bildung eines Legierungsblocks;
d) Anwenden von thermo-mechanischen Verarbeitungsschritten auf den Legierungsblock, um ein Knetprodukt zu bilden.

2. Verfahren nach Anspruch 1, wobei das Knetprodukt eine feine und gleichmäßige ASTM-Korngröße von 5 bis 10 aufweist.

3. Verfahren nach Anspruch 1, wobei die thermo-mechanischen Verarbeitungsschritte in d) umfassen:
i) Schmieden des Legierungsblocks zur Bildung eines Knetprodukts; und
ii) Glühen des Knetprodukts bei einer Temperatur von 950 bis 1150°C.

4. Verfahren nach Anspruch 3, wobei das Knetprodukt ausgewählt ist aus der Gruppe, bestehend aus Folien, Blechen, Platten, Rohren und Stangen.

5. Verfahren nach Anspruch 3, wobei das Glühen in ii) zu mindestens 75 % Rekristallisation führt.

6. Verfahren nach Anspruch 1, wobei die thermo-mechanischen Verarbeitungsschritte in d) umfassen:
I) Walzen des Knetprodukts auf eine Zwischendicke;
II) Glühen des Knetprodukts von I) bei einer Temperatur von 950 bis 1150°C für einen Zeitraum von 30 Minuten bis 180 Minuten;
III) Walzen des Knetprodukts von II); und
IV) Glühen des Knetprodukts von III) bei einer Temperatur von 950 bis 1150°C für einen Zeitraum von 30 Minuten bis 180 Minuten und dann Abkühlen des Knetprodukts auf Raumtemperatur.

7. Verfahren nach Anspruch 6, wobei das Knetprodukt ausgewählt ist aus der Gruppe, bestehend aus Folien, Platten, Blechen, Rohren und Stangen.

8. Verfahren nach Anspruch 7, wobei das Glühen in II) und IV) zu einer Rekristallisation von mindestens 75 % führt.

9. Niob-haltiges Knetprodukt, das nach dem Verfahren von Anspruch 1 erhalten wird, wobei ein Knetprodukt mit einer der nachstehenden Zusammensetzungen ausgeschlossen ist:
- 0,40 ppm Si, 0,02 ppm B, 0,02 ppm Na, 0,07 ppm Al, 0,37 ppm P, 0,53 ppm S, < 0,01 ppm Cl, 0,08 ppm Ti, 0,02 ppm V, 0,03 ppm Cr, < 0,005 ppm Mn, 0,15 ppm Fe, < 0,001 ppm Co, 0,005 ppm Ni, < 0,01 ppm Cu, < 0,001 ppm Y, 0,21 ppm Zr, 4,5 ppm Mo, 0,03 ppm Hf, ≤ 1000 ppm Ta, 1,5 ppm W, 5 ppm C, 6 ppm N, 33 ppm O, wobei der Rest Niob ist;
- 20 ppm Si, 0,05 ppm B, < 0,01 ppm Na, 0,07 ppm Al, 0,75 ppm P, 0,01 ppm S, < 0,01 ppm Cl, 0,05 ppm Ti, 0,04 ppm V, 0,07 ppm Cr, 1,1 ppm Mn, 0,05 ppm Fe, 0,01 ppm Co, 0,04 ppm Ni, < 0,01 ppm Cu, 0,003 ppm Y, 0,19 ppm Zr, 4,3 ppm Mo, 0,02 ppm Hf, < 1000 ppm Ta, 3,9 ppm W, 8 ppm C, 4 ppm N, 28 ppm O, wobei der Rest Niob ist;
- 31 ppm Si, 0,09 ppm B, < 0,01 ppm Na, 0,05 ppm Al, 0,75 ppm P, 0,05 ppm S, 0,05 ppm Cl, 0,07 ppm Ti, 0,02 ppm V, 0,05 ppm Cr, < 0,005 ppm Mn, 0,49 ppm Fe, 0,03 ppm Co, 0,01 ppm Ni, 0,02 ppm Cu, 0,003 ppm Y, 0,19 ppm Zr, 4,5 ppm Mo, 0,02 ppm Hf, ≤ 1000 ppm Ta, 1,5 ppm W, 8 ppm C, 8 ppm N, 31 ppm O, wobei der Rest Niob ist;
- 29 ppm Si, 0,03 ppm B, 0,03 ppm Na, 0,09 ppm Al, 2,1 ppm P, 0,92 ppm S, < 0,01 ppm Cl, 0,06 ppm Ti, 0,02 ppm V, 0,05 ppm Cr, < 0,005 ppm Mn, 0,42 ppm Fe, 0,002 ppm Co, 0,02 ppm Ni, < 0,01 ppm Cu, < 0,001 ppm Y, 0,21 ppm Zr, 4,3 ppm Mo, 0,04 ppm Hf, ≤ 1000 ppm Ta, 2,5 ppm W, 4 ppm C, 12 ppm N, 58 ppm O, wobei der Rest Niob ist;
- 40 ppm Si, 0,09 ppm B, < 0,01 ppm Na, 0,15 ppm Al, 0,52 ppm P, 0,05 ppm S, < 0,01 ppm Cl, 0,04 ppm Ti, 0,02 ppm V, 0,05 ppm Cr, < 0,005 ppm Mn, 0,27 ppm Fe, < 0,001 ppm Co, 0,009 ppm Ni, 0,02 ppm Cu, < 0,001 ppm Y, 0,15 ppm Zr, 3,8 ppm Mo, < 0,01 ppm Hf, ≤ 800 ppm Ta, 1,5 ppm W, 5 ppm C, 9 ppm N, 33 ppm O, wobei der Rest Niob ist;
- 60 ppm Si, 0,05 ppm B, < 0,01 ppm Na, 0,08 ppm Al, 1,9 ppm P, 0,53 ppm S, < 0,01 ppm Cl, 0,03 ppm Ti, 0,01 ppm V, 0,03 ppm Cr, < 0,005 ppm Mn, 0,51 ppm Fe, < 0,001 ppm Co, 0,02 ppm Ni, 0,05 ppm Cu, 0,005 ppm Y, 0,22 ppm Zr, 3,7 ppm Mo, 0,02 ppm Hf, ≤ 1000 ppm Ta, 2,5 ppm W, 7 ppm C, 4 ppm N, 42 ppm O, wobei der Rest Niob ist.

10. Knetprodukt nach Anspruch 9, wobei das Knetprodukt ausgewählt ist aus der Gruppe, bestehend aus einer Folie, einem Blech, einer Platte, einem Rohr und einer Stange.

11. Tiefgezogene Becher, hergestellt aus dem Knetprodukt nach Anspruch 9.

12. Sputtertargets, hergestellt aus dem Knetprodukt nach Anspruch 9.

## Revendications

1. Procédé de production d'un produit corroyé contenant du niobium, comprenant :
a) la fonte de niobium pour former une masse fondue ;
b) l'addition de 0,1 à 60 ppm d'un métal choisi dans le groupe constitué par l'yttrium, l'aluminium, le hafnium, le titane, le zirconium, le thorium, le lanthane et le cérium, basé sur le niobium dans la masse fondue ;
c) le refroidissement de la masse fondue pour former un lingot d'alliage ;
d) l'application d'étapes de traitement thermomécanique au lingot d'alliage pour former un produit corroyé.

2. Procédé selon la revendication 1, dans lequel le produit corroyé a une granulométrie ASTM fine et uniforme de 5 à 10.

3. Procédé selon la revendication 1, dans lequel les étapes de traitement thermomécanique dans d) comprennent :
i) le forgeage du lingot d'alliage pour former un produit corroyé ; et
ii) le recuit du produit corroyé à une température de 950 à 1150°C.

4. Procédé selon la revendication 3, dans lequel le produit corroyé est choisi dans le groupe constitué par les feuilles, les tôles, les plaques, les tubes et les barres.

5. Procédé selon la revendication 3, dans lequel le recuit dans ii) a pour résultat une cristallisation d'au moins 75 %.

6. Procédé selon la revendication 1, dans lequel les étapes de traitement thermomécanique dans d) comprennent :
I) le laminage du produit corroyé à une épaisseur intermédiaire ;
II) le recuit du produit corroyé de I) à une température de 950 à 1150°C pendant une période de 30 minutes à 180 minutes ;
III) le laminage du produit corroyé de II) ; et
IV) le recuit du produit corroyé de III) à une température de 950 à 1150°C pendant une période de 30 minutes à 180 minutes et ensuite le retour à la température ambiante du produit corroyé.

7. Procédé selon la revendication 6, dans lequel le produit corroyé est choisi dans le groupe constitué par les feuilles, les tôles, les plaques, les tubes et les barres.

8. Procédé selon la revendication 7, dans lequel les recuits dans II) et IV) résultent en une recristallisation d'au moins 75 %.

9. Produit corroyé contenant du niobium obtenu conformément au procédé de la revendication 1, à l'exclusion d'un produit corroyé ayant l'une des compositions suivantes
- 0,40 ppm de Si, 0,02 ppm de B, 0,02 ppm de Na, 0,07 ppm d'Al, 0,37 ppm de P, 0,53 ppm de S, < 0,01 ppm de Cl, 0,08 ppm de Ti, 0,02 ppm de V, 0,03 ppm de Cr, < 0,005 ppm de Mn, 0,15 ppm de Fe, < 0,001 ppm de Co, 0,005 ppm de Ni, < 0,01 ppm de Cu, < 0,001 ppm de Y, 0,21 ppm de Zr, 4,5 ppm de Mo, 0,03 ppm de Hf, ≤ 1000 ppm de Ta, 1,5 ppm de W, 5 ppm de C, 6 ppm de N, 33 ppm d'O, le reste étant du niobium ;
- 20 ppm de Si, 0,05 ppm de B, < 0,01 ppm de Na, 0,07 ppm d'Al, 0,75 ppm de P, 0,01 ppm de S, < 0,01 ppm de Cl, 0,05 ppm de Ti, 0,04 ppm de V, 0,07 ppm de Cr, 1,1 ppm de Mn, 0,05 ppm de Fe, 0,01 ppm de Co, 0,04 ppm de Ni, < 0,01 ppm de Cu, 0,003 ppm de Y, 0,19 ppm de Zr, 4,3 ppm de Mo, 0,02 ppm de Hf, ≤ 1000 ppm de Ta, 3,9 ppm de W, 8 ppm de C, 4 ppm de N, 28 ppm d'O, le reste étant du niobium ;
- 31 ppm de Si, 0,09 ppm de B, < 0,01 ppm de Na, 0,05 ppm d'Al, 0,75 ppm de P, 0,05 ppm de S, 0,05 ppm de Cl, 0,07 ppm de Ti, 0,02 ppm de V, 0,05 ppm de Cr, < 0,005 ppm de Mn, 0,49 ppm de Fe, 0,03 ppm de Co, 0,01 ppm de Ni, 0,02 ppm de Cu, 0,003 ppm de Y, 0,19 ppm de Zr, 4,5 ppm de Mo, 0,02 ppm de Hf, ≤ 1000 ppm de Ta, 1,5 ppm de W, 8 ppm de C, 8 ppm de N, 31 ppm d'O, le reste étant du niobium ;
- 29 ppm de Si, 0,03 ppm de B, 0,03 ppm de Na, 0,09 ppm d'Al, 2,1 ppm de P, 0,92 ppm de S, < 0,01 ppm de Cl, 0,06 ppm de Ti, 0,02 ppm de V, 0,05 ppm de Cr, < 0,005 ppm de Mn, 0,42 ppm de Fe, 0,002 ppm de Co, 0,02 ppm de Ni, < 0,01 ppm de Cu, < 0,001 ppm de Y, 0,21 ppm de Zr, 4,3 ppm de Mo, 0,04 ppm de Hf, ≤ 1000 ppm de Ta, 2,5 ppm de W, 4 ppm de C, 12 ppm de N, 58 ppm d'O, le reste étant du niobium ;
- 40 ppm de Si, 0,09 ppm de B, < 0,01 ppm de Na, 0,15 ppm d'Al, 0,52 ppm de P, 0,05 ppm de S, < 0,01 ppm de Cl, 0,04 ppm de Ti, 0,02 ppm de V, 0,05 ppm de Cr, < 0,005 ppm de Mn, 0,27 ppm de Fe, < 0,001 ppm de Co, 0,009 ppm de Ni, 0,02 ppm de Cu, < 0,001 ppm de Y, 0,15 ppm de Zr, 3,8 ppm de Mo, < 0,01 ppm de Hf, ≤ 800 ppm de Ta, 1,5 ppm de W, 5 ppm de C, 9 ppm de N, 33 ppm d'O, le reste étant du niobium ;
- 60 ppm de Si, 0,05 ppm de B, < 0,01 ppm de Na, 0,08 ppm d'Al, 1,9 ppm de P, 0,53 ppm de S, < 0,01 ppm de Cl, 0,03 ppm de Ti, 0,01 ppm de V, 0,03 ppm de Cr, < 0,005 ppm de Mn, 0,51 ppm de Fe, < 0,001 ppm de Co, 0,02 ppm de Ni, 0,05 ppm de Cu, 0,005 ppm de Y, 0,22 ppm de Zr, 3,7 ppm de Mo, 0,02 ppm de Hf, ≤ 1000 ppm de Ta, 2,5 ppm de W, 7 ppm de C, 4 ppm de N, 42 ppm d'O, le reste étant du niobium.

10. Produit corroyé selon la revendication 9, dans lequel le produit corroyé est choisi dans le groupe constitué par une feuille, une tôle, une plaque, un tube et une barre.

11. Coupelles embouties préparées à partir du produit corroyé selon la revendication 9.

12. Cibles de pulvérisation cathodiques préparées à partir du produit corroyé selon la revendication 9.
